# EUROPEAN PATENT SPECIFICATION

(11) **EP 3 570 647 B1**
(45) Date of publication and mention of the grant of the patent: **13.04.2022**
(21) Application number: 18172817.1
(22) Date of filing: 17.05.2018
(51) Int. Cl.: H05K 3/00

(54) **MODULE FOR A MONITORING SYSTEM AND MONITORING SYSTEM HAVING THE MODULE**
MODUL FÜR EIN ÜBERWACHUNGSSYSTEM UND ÜBERWACHUNGSSYSTEM MIT DEM MODUL
MODULE POUR UN SYSTÈME DE SURVEILLANCE ET SYSTÈME DE SURVEILLANCE POSSÉDANT CE MODULE

(43) Date of publication of application: 20.11.2019
(73) Proprietor: Robert Bosch GmbH, 70442 Stuttgart (DE)
(72) Inventor: Klupsch, Oliver, 85604 Zorneding (DE); Ribeiro, Francisco, 3030-183 Coimbra (PT); Spiess, Sebastian, 81827 Muenchen (DE)

(56) References cited:
- DE-A1- 10 127 057
- US-B1- 7 204 701
- US-B2- 9 255 702

## Description

### Prior art

The invention relates to a module for a monitoring system having the features of the pre-characterizing clause of Claim 1. The invention also relates to a monitoring system having the module.

Central units are known which are used to control an alarm system. The central unit can be networked with at least one detector, wherein the detector, upon detecting an alarm, reports this to the central unit. Central units of this type usually have multiple electronic modules which, for example, are connected to one another via an internal bus. It is also known to provide heat-producing components of the electronic modules with a heat sink, in order to enlarge the heat-emitting surface and thus to improve the cooling of these components.

The document US 9255702 B2, which forms the closest prior art, describes a light emitting diode (LED) lightning module is disclosed. The LED lighting module includes a heat sink, a circuit board, a carrier, semiconductor chips such as LEDs arranged on an upper surface of the carrier, and at least one holding device pressing a lower surface of the substrate against an upper surface of the heat sink. The semiconductor chips are electrically connected to the carrier. The carrier is electrically connected to the circuit board.

The document DE 101 27 057 A1 describes a security system which is constructed modularly and wherein the modules can be installed and removed during the operation of the security system. The modules are connected to one another via an internal bus, and this bus is formed as an optical bus. The security systems can be networked with one another, the security systems then also having access to the modules of other security systems.

### Disclosure of the invention

Within the context of the invention, a module having the features of Claim 1 is proposed. Furthermore, a monitoring system having the features of Claim 12 is proposed. Preferred and/or advantageous embodiments of the invention can be gathered from the sub-claims, the following description and the appended figures.

According to the invention, a module is proposed which is particularly designed and/or suitable for a monitoring system. The module is preferably a constituent part of a modular central unit, which is designed and/or suitable for controlling and/or monitoring the alarm system. The module can be formed as a functional module, in particular a control and/or regulating and/or indicating and/or supply and/or transmission module. Alternatively, the module can also be a constituent part of a decentralized operating and/or display unit, which is designed and/or suitable for controlling and/or monitoring the alarm system and/or the central unit.

The module has a main circuit board, the main circuit board having a printed circuit board and at least one or exactly one electromagnetic radiating component. In particular, the printed circuit board is used for the mechanical and/or electrical connection of the component in a housing of the module. The electromagnetic radiating component is arranged on the printed circuit board and contact is made therewith via at least one conductor track. The electromagnetic radiating component can be formed as a power component, in particular a semiconductor or processor. Alternatively, the electromagnetic radiating component can be a resistor, capacitor, conductor or inductor. Especially the electromagnetic radiating component generates an electromagnetic field and emits thermal energy during an operation of the module.

The module has a cooling device, which is designed and/or suitable for cooling the electromagnetic radiating component. The cooling device is preferably used to dissipate the thermal energy to the surroundings, wherein the thermal energy is in particular dissipated to the surroundings via thermal radiation and/or convection. The cooling device is in particular formed as a passive cooling device. The cooling device can be mechanically connected in a form-fitting and/or force-fitting and/or frictional manner to the main circuit board.

The cooling device is coupled thermally to the electromagnetic radiating component, so that a transfer of heat between the cooling device and the electromagnetic radiating component is implemented. In particular, the transfer of heat between the cooling device and the electromagnetic radiating component is carried out by thermal conduction, wherein a heat flow between the cooling device and the component is preferably implemented on the basis of a temperature difference.

Within the context of the invention, it is proposed that the cooling device have at least one metallic and one insulating heat-conducting element. The metallic and/or the insulating heat-conducting element preferably has/have a thermal conductivity of more than 100 W/(m*K), preferably more than 200 W/(m*K), in particular more than 300 W/(m*K). According to the invention, the insulating heat-conducting element is thermally conductive and not electrically conductive or is electrically insulating. The insulating heat-conducting element is preferably a ceramic heat-conducting element. For example, the insulating heat-conducting element can be made from an industrial ceramic. Alternatively, the insulating heat-conducting element can be made from plastic or a foam or any other material which has the mentioned characteristics. The insulating heat-conducting element preferably has an electrical conductivity of less than 10⁻⁸ S/m. Especially the insulating heat-conducting element has a good heat conductivity but is not electrical conductive.

The metallic heat-conducting element has a free area. According to the invention, the free area is formed as a material-free area, so that the metallic heat-conducting element is prevented from making contact with the electromagnetic radiating component by the free area. As a result, intensification of the electromagnetic field in the free area is further reduced or prevented. Preferably, the free area is formed as a cut-out or an aperture.

The electromagnetic radiating element and the insulating heat-conducting element are arranged at least in sections in the free area. Particularly preferably, the insulating heat-conducting element and the metallic heat-conducting element are in contact with each other, so that the transfer of heat between the insulating heat-conducting element and the metallic heat-conducting element is implemented by thermal conduction.

The electromagnetic radiating component is coupled thermally to the metallic heat-conducting element via the insulating heat-conducting element, so that an electromagnetic coupling path between the metallic heat-conducting element and the electromagnetic radiating component is reduced. The insulating heat-conducting element and/or the metallic heat-conducting element is/are used in particular to enlarge the heat-emitting surface of the electronic component. The insulating heat-conducting element is preferably in direct thermal contact with the electronic component and/or with the metallic heat-conducting element.

The advantage of the invention consists in particular in the fact that, by means of the insulating heat-conducting element, intensification of electric and/or magnetic fields, in particular electromagnetic radiation, by the cooling device is prevented or considerably reduced. As a result of the additional arrangement of the metallic heat-conducting element, the heat-emitting surface can additionally be enlarged further, by which means the cooling power of the cooling device can be improved considerably. Furthermore, the production costs of the cooling device can be reduced by the combination of the two heat-conducting elements.

In a preferred refinement of the invention, a heat-conducting path for contact heat transmission extends from the electromagnetic radiating component via the insulating heat-conducting element to the metallic heat-conducting element. In particular, the insulating heat-conducting element makes thermal and/or physical contact with the electromagnetic radiating component, at least in some sections, so that the transfer of heat is implemented by contact between the insulating heat-conducting element and the electromagnetic radiating component. For example, gap pads or gapfillers can be used to make contact between the insulating heat-conducting element and the electromagnetic radiating component.

In a further practical implementation, the insulating heat-conducting element has at least one or exactly one edge section. The edge section is in particular bounded by an outer edge of the heat-conducting element and/or defined by an edge region of the heat-conducting element. For example, the edge section has a width of more than 5 mm, preferably more than 10 mm, in particular more than 20 mm. In principle, the edge section can be formed as a peripheral edge section, the edge section extending completely along the outer edge of the insulating heat-conducting element. Alternatively, the edge section can extend and/or be interrupted in some sections along the outer edge of the insulating heat-conducting element. Alternatively, the edge section can be defined by the side walls of the insulating heat-conducting element.

Preferably, the insulating heat-conducting element has a plurality of edge sections, preferably at least two edge sections, a left-hand and/or right-hand and/or upper and/or lower side edge respectively forming one of the edge sections.

The insulating heat-conducting element is coupled thermally to the metallic heat-conducting element via the edge section, so that the heat-conducting path extends over the edge section to the metallic heat-conducting element. The insulating heat-conducting element is preferably arranged for the most part in the free area, only the edge section being arranged outside the free area. In particular, the edge section of the insulating heat-conducting element rests flat, in particular over the entire area, on the metallic heat-conducting element. Alternatively, the insulating heat-conducting element is positively arranged in the free area, wherein the size of the free area is at least approximately equal to size of the insulating heat-conducting element.

In a practical configuration, the free area is larger than or equal to the geometric dimensions of the electromagnetic radiating component. In particular, the free area is larger than or equal to a component diameter and/or length and/or width, of the electromagnetic radiating component. In particular, the form of the free area corresponds at least approximately to an external contour of the electromagnetic radiating component. Particularly preferably, the metallic heat-conducting element is arranged to be spaced uniformly away from the electromagnetic radiating component by the free area.

In a further practical configuration of the invention, provision is made for the main circuit board to have at least one or exactly one further electromagnetic radiating component. The electromagnetic radiating component and/or the further electromagnetic radiating component being arranged in a component area on the printed circuit board. Preferably, the electromagnetic radiating components are arranged in a common component area on the printed circuit board. Alternatively, the electromagnetic radiating components can be arranged separately from one another in different component areas on the main circuit board. In particular, the main circuit board has more than five, preferably more than 10, in particular more than 50 of the electromagnetic radiating components. Preferably, all the electromagnetic radiating components are arranged in a common component area. Especially most of the electromagnetic radiating components, which are in particular main contributors for electromagnetic radiation, are arranged in the free area.

The free area is designed to be greater than or equal to the component area. In particular, the component area is the area of the printed circuit board which is not covered by the metallic heat-conducting element and/or covered by the free area. Thus, the metallic heat-conducting element is arranged outside the electromagnetic radiating components and/or the component area. The form of the free area preferably corresponds at least approximately to the form of the electromagnetic radiating components and/or the component area. In particular, the metallic heat-conducting element can adjoin the component area.

In a further practical configuration, provision is made for at least one or exactly one heat-conducting layer to be arranged between the insulating heat-conducting element and the metallic heat-conducting element. The heat-conducting layer serves to compensate for irregularities in the surfaces and thus for the improved transfer of heat between the insulating heat-conducting element and the metallic heat-conducting element. The heat-conducting layer is preferably formed by a heat-conducting paste or a heat-conducting pad. In particular, the heat-conducting pad can be formed as a thermoplastic pad or a metal foil. Particularly preferably, the heat-conducting pad is formed as a thin graphite sheet or graphite pad.

In a preferred development, the heat-conducting layer is arranged within the edge section of the insulating heat-conducting element. Particularly preferably, the heat-conducting layer extends over the entire area of the at least one edge section. In particular, each of the edge sections has the heat-conducting layer, so that the metallic heat-conducting element is coupled exclusively via the heat-conducting layer to the insulating heat-conducting element, in particular the edge section. Thus, the heat-conducting path extends from the edge section via the heat-conducting layer to the metallic heat-conducting element.

In a practical implementation, the electromagnetic radiating component has a contact face and the insulating heat-conducting element has a contact section. In particular, the contact face is formed as a level or planar face. The contact section can adjoin at least one edge section directly. Preferably, the contact section and the edge section extend in a common plane. The contact face rests on the entire area of the contact section. The electromagnetic radiating component can rest directly with the contact face on the contact section. Alternatively, however, the electromagnetic radiating component can rest on the contact section via a further heat-conducting layer, the further heat-conducting layer being arranged between the contact face and the contact section.

In a further practical configuration, the insulating heat-conducting element is of plate-like form, wherein the contact section is formed as a flat surface. Optionally, the metallic heat-conducting element is of plate-like form. In particular, the insulating heat-conducting element and/or the metallic heat-conducting element have a rectangular shape. Preferably, the both heat-conducting elements rest flat against each other. Particularly preferably, the insulating heat-conducting element and/or the metallic heat-conducting element rest flat on the heat-conducting layer. Optionally, the insulating heat-conducting element and/or the metallic heat-conducting element can have a cooling structure, e.g. cooling ribs, etc.

In a further practical implementation, provision is made for the contact section to be arranged within the component area. In particular, the contact section extends exclusively within the component area, the entire area of the contact section preferably being smaller than or equal to the total area of the component area. In particular, the contact section extends for the most part or completely over the entire component area. Particularly preferably, all the heat-emitting components of the component area are coupled thermally to the contact section.

The insulating heat-conducting element is connected to the metallic heat-conducting element only via the edge section. Preferably, the insulating heat-conducting element is arranged exclusively with the edge section outside the component area. Particularly preferably, the heat-conducting path thus extends from the electromagnetic radiating component, via its contact face, the contact section, the edge section, in particular the heat-conducting layer, to the metallic heat-conducting element.

In a practical constructive configuration, provision is made for the two heat-conducting elements to be connected to each other via at least one fixing means. In particular, a force fit and/or a form fit between the two heat-conducting elements is implemented by the fixing means. Particularly preferably, a constant fixing pressure between the two heat-conducting elements, in particular the edge section and the metallic heat-conducting element, is produced by the fixing means.

The insulating heat-conducting element and the metallic heat-conducting element each have a fixing means receptacle, which is designed and/or suitable to receive the fixing means. In particular, the fixing means receptacles are formed as openings, for example drilled holes and/or slots. Particularly preferably, all the fixing means receptacles of the insulating heat-conducting element are arranged within the edge section. The fixing means can be formed as a screw and/or clamping means. In particular, fixing means are formed as plastic rivets or as screw connection.

A further subject of the invention relates to a monitoring system having the module as has already been described previously or according to one of the preceding claims. The monitoring system can be formed as a alarm system, in particular as a fire alarm system and/or a burglar alarm system, and/or as a access control system and/or as a video system and/or as an evacuation system. The alarm system preferably has at least one detector for detecting an alarm, the detector having a signal connection to the central unit. The module can be designed to control and/or monitor the at least one detector.

Further features, advantages and defects of the invention can be gathered from the following description of preferred exemplary embodiments of the invention. In the drawing:
- Figure 1: shows a schematic illustration of an alarm system as an exemplary embodiment of the invention;
- Figure 2: shows a schematic illustration of a module of the alarm system;
- Figure 3: shows an exploded illustration of a cooling device of the module from Figure 2.

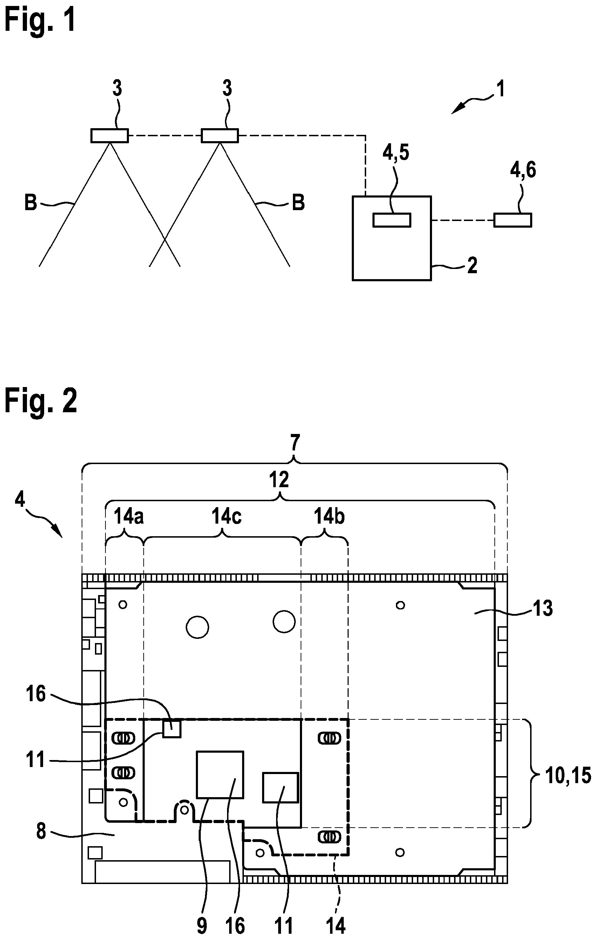

Figure 1 shows, in a highly simplified schematic illustration, an alarm system 1 which, for example, is designed and/or suitable for monitoring a building. For example, the alarm system 1 is formed as a fire alarm system or as a burglar alarm system.

The alarm system 1 has a modular central unit 2, multiple detectors 3 and multiple electronic modules 4, the detectors 3 and the modules 4 having a signal connection to one another via the central unit 2. The modules 4 are used, for example, to display an operating status and/or to control and/or monitor the alarm system 1, in particular the detectors 3. One of the modules 4 can, for example, be formed as a central controller 5, wherein the central controller 5 being arranged within the central unit 2 for this purpose. A further module 4 can, for example, be formed as a decentralized operating unit 6, the operating unit 6 being arranged outside the central unit 2.

For example, the alarm system 1 can have more than five, preferably more than 10, in particular more than 50 of the detectors 3. The detectors 3 are used to detect an alarm and can be formed, for example, as a movement detector, glass breakage detector, fire detector, smoke detector, etc. For this purpose, each of the detectors 3 has a monitoring area B, the detector 3 detecting an alarm within the monitoring area B and reporting the same to the central unit 2.

Figure 2 shows a schematic illustration of one of the modules 4 from Figure 1. The module 4 has a main circuit board 7, the main circuit board 7 comprising a printed circuit board 8 and at least one electromagnetic radiating component 9. The component 9 is arranged on the printed circuit board 8 in a component area 10 and contact can be made therewith via at least one conductor track. The electromagnetic radiating component 9 is formed, for example, as a power component, the component 9 emitting thermal energy, for example, during the operation of the module 4 and at the same time generating an electromagnetic field.

The main circuit board 7 has further electronic components and/or further electromagnetic radiating components 11, which can likewise be arranged inside or outside the component area 10 on the printed circuit board 8, and with which contact can be made as desired via conductor tracks. For example, the further components 11 can emit thermal energy and/or generate an electromagnetic field. Especially the further components 11, which are main contributors for electromagnetic radiation, being arranged in the component area 10. For example, the electronic components 9, 11 can be formed as a CPU and/or power semiconductor and/or microcontroller.

In addition, the module 4 has a cooling device 12, the cooling device 12 being mounted on the main circuit board 7. The cooling device 12 is used to cool the components 9, 11, in particular the heat-producing components. For this purpose, the cooling device 12 is coupled thermally to the corresponding components 9, 11, the heat-emitting surface of the components 9, 11 being enlarged by the cooling device 12. For example, the cooling device 12 is formed as a passive cooling device, wherein transporting heat away and thus the cooling of the components is implemented by convection.

The cooling device 12 has a metallic heat-conducting element 13 and a insulating heat-conducting element 14 which, in the exemplary embodiment shown, is indicated only schematically. The two elements 13, 14 are formed as heat-conducting plates, wherein the area of the metallic heat-conducting element 13 can be many times greater than that of the insulating heat-conducting element 14. For example, the metallic heat-conducting element 13 is formed as an aluminium heat-conducting plate. The insulating heat-conducting element 14 can be formed as a ceramic plate.

The metallic heat-conducting element 13 has a free area 15, the free area 15 being formed as a material-free area of the metallic heat-conducting element 13. The free area 15 is formed as a rectangular cut-out, wherein the free area 15 extending over the entire component area 10. Thus, the components 9, 11 which are arranged within the component area 10 are arranged to be free of contact and/or at a distance from the metallic heat-conducting element 13. Thus, intensification of the electromagnetic field is prevented or ruled out by the free area 15, because an electromagnetic coupling path between the metallic heat-conducting element and the electromagnetic radiating component is reduced or is attenuated.

The insulating heat-conducting element 14 extends within the component area 10 and, in order to transfer heat, is coupled thermally firstly to at least the components 9, 11 formed as heat-emitting components and secondly to the metallic heat-conducting element 13. The insulating heat-conducting element 14 has a left-hand and a right-hand edge section 14a, b, and a contact section 14c. The two edge sections 14a, b are each formed as an outer side edge or edge region of the insulating heat-conducting element 14, the insulating heat-conducting element being in direct thermal contact with the metallic heat-conducting plate 13 exclusively via the two edge sections 14a, b.

The contact section 14c extends between the two edge sections 14a, b, wherein the contact section 14c connecting the two edge sections 14a, b directly to each other. The contact section 14c is used to make contact with the heat-emitting components 9, 11, wherein the contact section making direct contact with the components 9, 11, for example, for this purpose. The heat-emitting components 9, 11 have a contact face 16, wherein all the heat-emitting components 9, 11 resting flat on the contact section 14c via the contact face 16. Thus, a heat-conducting path for contact heat transmission extends from the heat-emitting components 9, 11, via their contact face 16, the contact section 14c, the two edge sections 14a, b to the metallic heat-conducting element 13.

Thus, the transfer of heat between the electronic components 9, 11 and the metallic heat-conducting element 13 in the component area 10 can take place by means of the insulating heat-conducting element 14, wherein the coupling from the electromagnetic field of the components 9, 11 to the metallic heat-conducting element 13 is reduced or is attenuated. In addition, as a result of the thermal connection of the two heat-conducting elements 13, 14, the effective surface can be enlarged; at the same time the production costs can be reduced in comparison with an complete ceramic heat-conducting part.

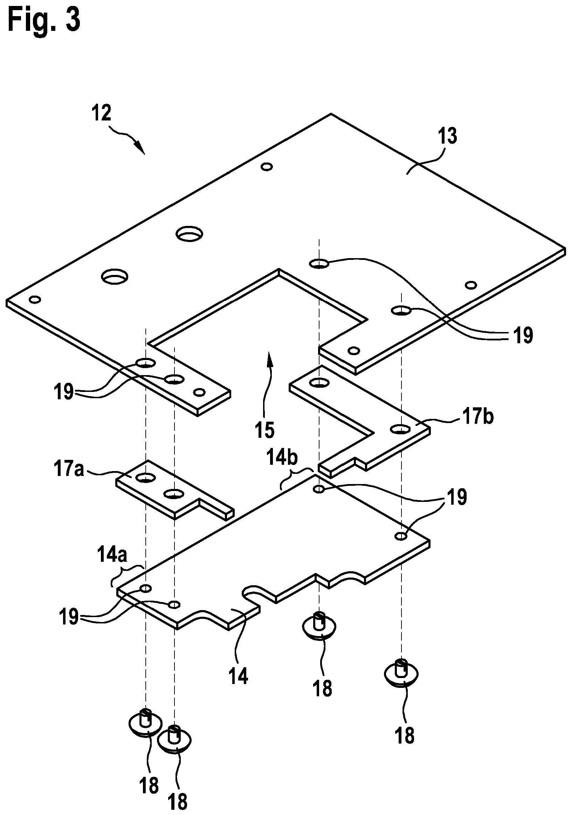

Figure 3 shows an exploded illustration of the cooling device 12 from Figure 2. The cooling device 12 has a first and a second heat-conducting pad 17a, b as a heat-conducting layer. For example, the two heat-conducting pads 17a, b are formed as graphite pads. The heat-conducting pads 17a, b are used to compensate for surface irregularities, by which means the transfer of heat between the two heat-conducting elements 13, 14 is improved.

The two heat-conducting pads 17a, b are arranged between the metallic and the insulating heat-conducting elements 13, 14. The first heat-conducting pad 17a is arranged within the left-hand edge section 14a, and the second heat-conducting pad 17b is arranged within the right-hand edge section 14b. For example, the two heat-conducting pads 17a, b extend over the entire area in the respective edge section 14a, b; for this purpose the heat-conducting pads 17a, b can have the same or a similar contour to the associated edge section 14 a, b.

The cooling device 12 has multiple fixing means 18, the two heat-conducting elements 13, 14 each having multiple fixing means receptacles 19 to receive the fixing means 18. By means of the fixing means 18, the two heat-conducting elements 13, 14 can be or are connected to each other with a form fit and/or force fit. For this purpose, respectively one of the fixing means 18 is arranged in one of the fixing means receptacles 19 of the insulating heat-conducting element 14 and of the metallic heat-conducting element 13. The fixing means receptacles 19 of the insulating heat-conducting element 14 are arranged exclusively within the two edge sections 14a, b. For example, the fixing means 14 are formed as plastic rivets or as screws, wherein a constant fixing pressure on the two heat-conducting elements 13, 14 and the interposed heat-conducting pads 17a, b being generated by the fixing means 14 formed as plastic rivets.

## Claims

1. Module (4),
having a main circuit board (7),
wherein the main circuit board (7) has a printed circuit board (8) and at least one electromagnetic radiating component (9), wherein the electromagnetic radiating component (9) is arranged on the printed circuit board (8) and being contacted via at least one conductor track,
having a cooling device (12) for cooling the electromagnetic radiating component (9), wherein the cooling device (12) being coupled thermally to the electromagnetic radiating component (9), so that a transfer of heat between the cooling device (12) and the electromagnetic radiating component (9) is implemented, wherein the cooling device (12) has at least one metallic heat-conducting element (13), wherein the metallic heat-conducting element (13) has a free area (15),
**characterized in that**
the cooling device (12) has an insulating heat-conducting element (14), wherein the insulating heat-conducting element is thermally conductive and electrically insulating, wherein the electromagnetic radiating component (9) is coupled thermally to the metallic heat-conducting element (13) via the insulating heat-conducting element (14), wherein the free area (15) being formed as a material-free area of the metallic heat-conducting element (13), wherein the electromagnetic radiating component (9) and the insulating heat-conducting element (14) are arranged at least in sections in the free area (15), so that an electromagnetic coupling path between the metallic heat-conducting element (13) and the electromagnetic radiating component (9) is reduced.

2. Module (4) according to Claim 1, **characterized in that** a heat-conducting path for contact heat transmission extends from the electromagnetic radiating component (9) via the insulating heat-conducting element (14) to the metallic heat-conducting element (13).

3. Module (4) according to Claim 2, **characterized in that** the insulating heat-conducting element (14) has at least one edge section (14a, b), wherein the insulating heat-conducting element (14) is coupled thermally to the metallic heat-conducting element (13) via the edge section (14a, b), so that the heat-conducting path extends via the edge section (14a, b) to the metallic heat-conducting element (13).

4. Module (4) according to Claim 2 or 3, **characterized in that** the free area (15) is larger than or equal to the geometric dimensions of the electromagnetic radiating component (9).

5. Module (4) according to one of the preceding claims, **characterized in that** the main circuit board (7) has at least one further electromagnetic radiating component (11), wherein the at least one and/or the further electromagnetic radiating component (9, 11) is/are arranged in a component area (10) on the printed circuit board (8), wherein the free area (15) is designed to be larger or the same as the component area (15).

6. Module (4) according to one of the preceding claims, **characterized in that** at least one heat-conducting layer (17a, b) is arranged between the metallic and the insulating heat-conducting element (13, 14).

7. Module (4) according to Claim 6, **characterized in that** the heat-conducting layer (17a, b) is arranged within the at least one edge section (14a, b) of the insulating heat-conducting element (14).

8. Module (4) according to one of the preceding claims, **characterized in that** the electromagnetic radiating component (9) and/or the further electromagnetic radiating component (11) has a contact face (16) and the insulating heat-conducting element (14) has a contact section (14c), wherein the contact face (16) rests on the contact section (14c).

9. Module (4) according to Claim 8, **characterized in that** the insulating heat-conducting element (14) are of plate-like form, wherein the contact section (14c) is formed as a flat surface.

10. Module (4) according to Claim 8 or 9, **characterized in that** the contact section (14c) is arranged within the component area (15), wherein the insulating heat-conducting element (14) is connected to the metallic heat-conducting element (13) only via the edge section (14a, b).

11. Module (4) according to one of the preceding claims, **characterized in that** the cooling device (12) has at least one fixing means (18), wherein the two heat-conducting elements (13, 14) are connected to each other via the fixing means (18), wherein the metallic and the insulating heat-conducting element (13, 14) each have a fixing means receptacle (19) to receive the fixing means (18).

12. Monitoring system (1) having the module according to one of the preceding claims.

## Patentansprüche

1. Modul (4),
das eine Hauptplatine (7) aufweist,
wobei die Hauptplatine (7) eine Leiterplatte (8) und mindestens eine elektromagnetisch abstrahlende Komponente (9) aufweist, wobei die elektromagnetisch abstrahlende Komponente (9) auf der Leiterplatte (8) angeordnet ist und über mindestens eine Leiterbahn kontaktiert wird,
das eine Kühlvorrichtung (12) zum Kühlen der elektromagnetisch abstrahlenden Komponente (9) aufweist, wobei die Kühlvorrichtung (12) derart thermisch mit der elektromagnetisch abstrahlenden Komponente (9) gekoppelt ist, dass eine Wärmeübertragung zwischen der Kühlvorrichtung (12) und der elektromagnetisch abstrahlenden Komponente (9) implementiert wird, wobei die Kühlvorrichtung (12) mindestens ein metallisches Wärmeleitungselement (13) aufweist, wobei das metallische Wärmeleitungselement (13) einen freien Bereich (15) aufweist,
**dadurch gekennzeichnet, dass**
die Kühlvorrichtung (12) ein isolierendes Wärmeleitungselement (14) aufweist, wobei das isolierende Wärmeleitungselement thermisch leitend und elektrisch isolierend ist, wobei die elektromagnetisch abstrahlende Komponente (9) thermisch mit dem metallischen Wärmeleitungselement (13) über das isolierende Wärmeleitungselement (14) gekoppelt ist, wobei der freie Bereich (15) als ein materialfreier Bereich des metallischen Wärmeleitungselements (13) ausgebildet ist, wobei die elektromagnetisch abstrahlende Komponente (9) und das isolierende Wärmeleitungselement (14) zumindest in Abschnitten in dem freien Bereich (15) angeordnet sind, so dass ein elektromagnetischer Kopplungspfad zwischen dem metallischen Wärmeleitungselement (13) und der elektromagnetisch abstrahlenden Komponente (9) reduziert wird.

2. Modul (4) nach Anspruch 1, **dadurch gekennzeichnet, dass** sich ein Wärmeleitungspfad für eine Kontaktwärmeübertragung von der elektromagnetisch abstrahlenden Komponente (9) über das isolierende Wärmeleitungselement (14) zu dem metallischen Wärmeleitungselement (13) erstreckt.

3. Modul (4) nach Anspruch 2, **dadurch gekennzeichnet, dass** das isolierende Wärmeleitungselement (14) mindestens einen Randabschnitt (14a, b) aufweist, wobei das isolierende Wärmeleitungselement (14) thermisch mit dem metallischen Wärmeleitungselement (13) über den Randabschnitt (14a, b) gekoppelt ist, so dass sich der Wärmeleitungspfad über den Randabschnitt (14a, b) zu dem metallischen Wärmeleitungselement (13) erstreckt.

4. Modul (4) nach Anspruch 2 oder 3, **dadurch gekennzeichnet, dass** der freie Bereich (15) größer als oder gleich zu den geometrischen Abmessungen der elektromagnetisch abstrahlenden Komponente (9) ist.

5. Modul (4) nach einem der vorhergehenden Ansprüche, **dadurch gekennzeichnet, dass** die Hauptplatine (7) mindestens eine weitere elektromagnetisch abstrahlende Komponente (11) aufweist, wobei die mindestens eine und/oder die weitere elektromagnetisch abstrahlende Komponente (9, 11) in einem Komponentenbereich (10) auf der Leiterplatte (8) angeordnet ist/sind, wobei der freie Bereich (15) so ausgestaltet ist, dass er größer oder gleich dem Komponentenbereich (15) ist.

6. Modul (4) nach einem der vorhergehenden Ansprüche, **dadurch gekennzeichnet, dass** mindestens eine Wärmeleitungsschicht (17a, b) zwischen dem metallischen und dem isolierenden Wärmeleitungselement (13, 14) angeordnet ist.

7. Modul (4) nach Anspruch 6, **dadurch gekennzeichnet, dass** die Wärmeleitungsschicht (17a, b) in dem mindestens einen Randabschnitt (14a, b) des isolierenden Wärmeleitungselements (14) angeordnet ist.

8. Modul (4) nach einem der vorhergehenden Ansprüche, **dadurch gekennzeichnet, dass** die elektromagnetisch abstrahlende Komponente (9) und/oder die weitere elektromagnetisch abstrahlende Komponente (11) eine Kontaktfläche (16) aufweist und das isolierende Wärmeleitungselement (14) einen Kontaktabschnitt (14c) aufweist, wobei die Kontaktfläche (16) auf dem Kontaktabschnitt (14c) ruht.

9. Modul (4) nach Anspruch 8, **dadurch gekennzeichnet, dass** das isolierende Wärmeleitungselement (14) eine plattenartige Form aufweist, wobei der Kontaktabschnitt (14c) als eine flache Oberfläche ausgebildet ist.

10. Modul (4) nach Anspruch 8 oder 9, **dadurch gekennzeichnet, dass** der Kontaktabschnitt (14c) in dem Komponentenbereich (15) angeordnet ist, wobei das isolierende Wärmeleitungselement (14) mit dem metallischen Wärmeleitungselement (13) nur über den Randabschnitt (14a, b) verbunden ist.

11. Modul (4) nach einem der vorhergehenden Ansprüche, **dadurch gekennzeichnet, dass** die Kühlvorrichtung (12) mindestens ein Befestigungsmittel (18) aufweist, wobei die zwei Wärmeleitungselemente (13, 14) miteinander über das Befestigungsmittel (18) verbunden sind, wobei das metallische und das isolierende Wärmeleitungselement (13, 14) jeweils eine Befestigungsmittelaufnahme (19) zum Aufnehmen des Befestigungsmittels (18) aufweisen.

12. Überwachungssystem (1), welches das Modul nach einem der vorhergehenden Ansprüche aufweist.

## Revendications

1. Module (4),
doté d'une carte principale (7) à circuit,
la carte principale (7) à circuit comprenant une carte (8) à circuit imprimé et au moins un composant rayonnant électromagnétique (9), le composant rayonnant électromagnétique (9) étant disposé sur la carte (8) à circuit imprimé et étant mis en contact par l'intermédiaire d'au moins une piste conductrice,
doté d'un dispositif (12) de refroidissement servant à refroidir le composant rayonnant électromagnétique (9), le dispositif (12) de refroidissement étant couplé thermiquement au composant rayonnant électromagnétique (9), de sorte qu'un transfert de chaleur entre le dispositif (12) de refroidissement et le composant rayonnant électromagnétique (9) est réalisé, le dispositif (12) de refroidissement comprenant au moins un élément métallique (13) conduisant la chaleur, l'élément métallique (13) conduisant la chaleur présentant une zone libre (15),
**caractérisé en ce que**
le dispositif (12) de refroidissement comprend un élément isolant (14) conduisant la chaleur, l'élément isolant conduisant la chaleur étant thermiquement conducteur et électriquement isolant, le composant rayonnant électromagnétique (9) étant couplé thermiquement à l'élément métallique (13) conduisant la chaleur par l'intermédiaire de l'élément isolant (14) conduisant la chaleur, la zone libre (15) étant formée comme une zone libre de matériau de l'élément métallique (13) conduisant la chaleur, le composant rayonnant électromagnétique (9) et l'élément isolant (14) conduisant la chaleur étant disposés au moins dans des sections de la zone libre (15), de sorte qu'un trajet de couplage électromagnétique entre l'élément métallique (13) conduisant la chaleur et le composant rayonnant électromagnétique (9) est réduit.

2. Module (4) selon la revendication 1, **caractérisé en ce qu'**un trajet de conduction de chaleur servant à la transmission de chaleur par contact s'étend à partir du composant rayonnant électromagnétique (9), par l'intermédiaire de l'élément isolant (14) conduisant la chaleur, jusqu'à l'élément métallique (13) conduisant la chaleur.

3. Module (4) selon la revendication 2, **caractérisé en ce que** l'élément isolant (14) conduisant la chaleur comprend au moins une section (14a, b) de bord, l'élément isolant (14) conduisant la chaleur étant couplé thermiquement à l'élément métallique (13) conduisant la chaleur par l'intermédiaire de la section (14a, b) de bord, de sorte que le trajet de conduction de chaleur s'étend par l'intermédiaire de la section (14a, b) de bord jusqu'à l'élément métallique (13) conduisant la chaleur.

4. Module (4) selon la revendication 2 ou 3, **caractérisé en ce que** la zone libre (15) est supérieure ou égale aux dimensions géométriques du composant rayonnant électromagnétique (9).

5. Module (4) selon l'une des revendications précédentes, **caractérisé en ce que** la carte principale (7) à circuit comprend au moins un composant rayonnant électromagnétique supplémentaire (11), le ou les composants et/ou le composant rayonnant électromagnétique supplémentaire (9, 11) étant disposés dans une zone (10) de composants sur la carte (8) à circuit imprimé, la zone libre (15) étant conçu pour être plus grande ou la même que la zone (15) de composants.

6. Module (4) selon l'une des revendications précédentes, **caractérisé en ce qu'**au moins une couche (17a, b) conduisant la chaleur est disposée entre l'élément métallique et l'élément isolant (13, 14) conduisant la chaleur.

7. Module (4) selon la revendication 6, **caractérisé en ce que** la couche (17a, b) conduisant la chaleur est disposée à l'intérieur de la ou des sections (14a, b) de bord de l'élément isolant (14) conduisant la chaleur.

8. Module (4) selon l'une des revendications précédentes, **caractérisé en ce que** le composant rayonnant électromagnétique (9) et/ou le composant rayonnant électromagnétique supplémentaire (11) présentent une face (16) de contact et **en ce que** l'élément isolant (14) conduisant la chaleur est doté d'une section (14c) de contact, la face (16) de contact reposant sur la section (14c) de contact.

9. Module (4) selon la revendication 8, **caractérisé en ce que** l'élément isolant (14) conduisant la chaleur est de forme aplatie, la section (14c) de contact étant formée comme une surface plate.

10. Module (4) selon les revendications 8 ou 9, **caractérisé en ce que** la section (14c) de contact est disposée à l'intérieur de la zone (15) de composants, l'élément isolant (14) conduisant la chaleur n'étant relié à l'élément métallique (13) conduisant la chaleur que par l'intermédiaire de la section (14a, b) de bord.

11. Module (4) selon l'une des revendications précédentes, **caractérisé en ce que** le dispositif (12) de refroidissement est doté d'au moins un moyen (18) de fixation, les deux éléments (13, 14) conduisant la chaleur étant reliés l'un à l'autre par l'intermédiaire du moyen (18) de fixation, l'élément métallique et l'élément isolant (13, 14) conduisant la chaleur comprenant chacun un logement (19) pour moyen de fixation servant à recevoir le moyen (18) de fixation.

12. Système (1) de surveillance doté du module selon l'une des revendications précédentes.
